# EUROPÄISCHE PATENTSCHRIFT

(11) **EP 1 072 046 B1**
(45) Veröffentlichungstag und Bekanntmachung des Hinweises auf die Patenterteilung: **12.12.2001**
(21) Anmeldenummer: 99920653.5
(22) Anmeldetag: 07.04.1999
(51) Int. Cl.: H01H 27/04, H01R 13/703, H05K 5/00

(54) **MIT STECKVERBINDER VERSEHENE ELEKTRISCHE SCHALTUNG, INSBESONDERE STEUERGERÄT FÜR KRAFTFAHRZEUGE**
ELECTRIC CIRCUIT WITH A PLUG-IN CONNECTOR, ESPECIALLY A CONTROL DEVICE FOR MOTOR VEHICLES
CIRCUIT ELECTRIQUE MUNI DE CONNECTEURS A FICHES, NOTAMMENT DISPOSITIF DE COMMANDE POUR VEHICULES AUTOMOBILES

(30) Priorität: 16.04.1998 DE 19816904
(43) Veröffentlichungstag der Anmeldung: 31.01.2001
(73) Patentinhaber: SIEMENS AKTIENGESELLSCHAFT, 80333 München (DE); Volkswagen Aktiengesellschaft, 38436 Wolfsburg (DE)
(72) Erfinder: KOLAR, Robert, D-93346 Ihrlerstein (DE); LEHNST, Thomas, D-38104 Braunschweig (DE); PROBST, Heinrich, D-93105 Tegernheim (DE); DIRMEYER, Josef, D-92439 Bodenwöhr (DE)
(74) Vertreter: Zedlitz, Peter, Dipl.-Inf.
(86) Internationale Anmeldenummer: EP9902477
(87) Internationale Veröffentlichungsnummer: WO9954901

(56) Entgegenhaltungen:
- DE-A- 3 902 230
- DE-A- 4 436 547
- DE-U- 9 109 488
- US-A- 4 115 665

## Beschreibung

Die Erfindung betrifft eine mit Gehäuse versehene elektrische Schaltung, an der ein von außen zugängliches Steckverbinderelement angebracht ist. Vorzugsweise handelt es sich hierbei um ein Steuergerät für Kraftfahrzeuge, insbesondere um ein Steuergerät für ein Insassenschutzsystem eines Kraftfahrzeugs.

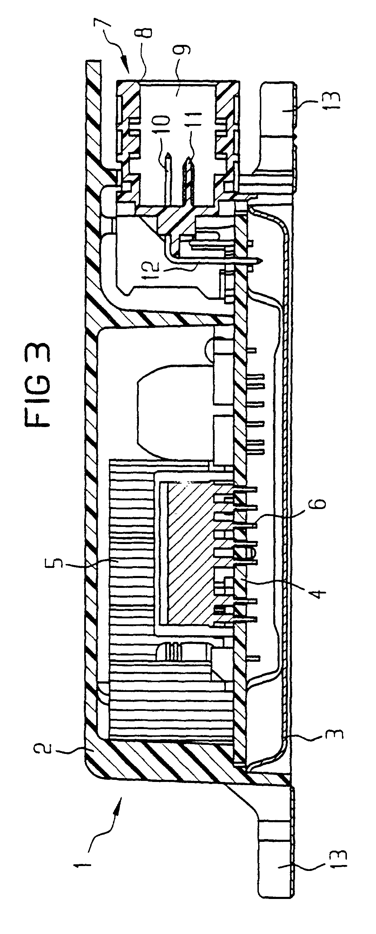

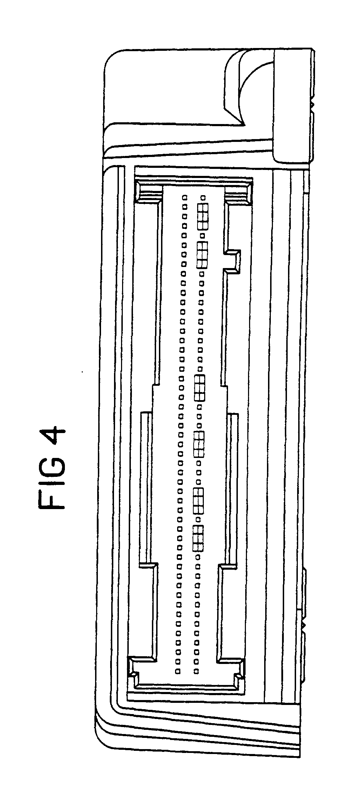

In den Fig. 3 und 4 ist eine bereits vorgeschlagene, auf internen Vorüberlegungen beruhende Ausführungsform einer elektrischen Schaltung in Form eines Steuergeräts 1 für ein Kraftfahrzeug-Airbagsystem dargestellt. Fig. 3 zeigt einen Querschnitt durch das Steuergerät 1, das ein Gehäuse 2 mit Deckel 3 aufweist. Das Gehäuse 2 und der Deckel 3 bilden einen allseits umschlossenen Innenraum, in dem eine Leiterplatte 4 angeordnet ist, auf deren Oberseite Bauelemente 5 positioniert sind. Die Bauelemente 5 sind mit Kontaktstiften 6 versehen, die durch entsprechende Öffnungen der Leiterplatte 4 hindurchgeführt sind und mit an der Leiterplattenunterseite vorhandenen, nicht gezeigten Leiterbahnen kontaktiert sind. Die Bauelemente 5 können aber auch teilweise oder insgesamt als oberflächenmontierbare Bauelemente ausgestaltet sein, die lediglich auf der Leiterplattenoberseite verdrahtet werden. Alternativ können auch auf der Leiterplattenunterseite Bauelemente angeordnet sein. Die Leiterplatte 4 liegt, wie in Fig. 3 gezeigt ist, auf entsprechenden Anlageschultern und Auflagevorsprüngen des Gehäuses 2 auf und wird durch den Dekkel 3 oder sonstige Mittel in der in Fig. 3 gezeigten Position festgelegt. Der nach unten ausgewölbte Deckel 3 stellt einen entsprechenden Hohlraum unterhalb der Leiterplatte 4 zur Aufnahme von ggf. auf der Leiterplatten-Lötseite (Unterseite) befindlichen Bauelementen sowie zur Bildung entsprechender Sicherheitsabstände zu diesen Bauelementen und den durch die Leiterplatte durchgeführten Kontaktstiften 6 der auf der Leiterplattenoberseite angeordneten Bauelemente 5 bereit.

Wie in Fig. 3 gezeigt ist, ist an einer Seitenwand des Steuergeräts 1 ein Steckverbinderelement 7 in Form eines Steckers angeordnet, der eine umlaufende Wandung 8 und einen innerhalb der Wandung 8 ausgebildeten Einsteckraum 9 zur Aufnahme eines entsprechend ausgebildeten Gegensteckers aufweist. Das Steckverbinderelement 7 ist durch eine Eingriffsverzahnung zwischen am Gehäuse 2 ausgebildeten Vorsprüngen und Vertiefungen einerseits und entsprechend geformten, am Steckverbinderelement 7 gebildeten Vertiefungen und Vorsprüngen andererseits fixiert, wie dies aus Fig. 3 ersichtlich ist. Hierdurch wird ein seitliches Verrutschen oder eine axiale Bewegung des Steckverbinderelements 7 beim Einstecken/Herausziehen des Gegensteckers verhindert. Der nicht dargestellte Gegenstecker ist vorzugsweise über eine flexible Leitung mit den zugehörigen, durch das Steuergerät 1 zu steuernden Komponenten, beispielsweise den Zündpillen des Airbagsystems, verbunden.

An der hinteren, dem Einsteckraum 9 zugewandten Wand des Steckverbinderelements 7 sind mehrere Kontaktelemente 10 in Form von Kontaktstiften (oder Buchsen) vorgesehen, die stekkerrückseitig, das heißt innerhalb des Gehäuses 2, durch gebogene, formstabile Verbindungsdrähte 12 in Form von metallischen Leiterdrähten oder Leiterstegen mit entsprechenden Anschlüssen der Leiterplatte 4 verbunden sind. Die Verbindungsdrähte 12 sind durch entsprechende Öffnungen der Leiterplatte 4 hindurchgeführt und können somit auf der Leiterplattenunterseite, das heißt auf der Lötseite, elektrisch kontaktiert, zum Beispiel verlötet werden.

Im Einsteckraum 9 sind ferner Kurzschlußunterbrecher 11 vorgesehen, die parallel zu den Kontaktstiften 10 verlaufen, jedoch einstückig mit der rückseitigen Steckerwandung ausgebildet und ggf. mit zusätzlichen, aufgeschobenen Kunststoffkappen versehen sind. Die Unterbrecherstifte (Kurzschlußunterbrecher) 11 sind elektrisch nicht leitend und auch nicht mit der Leiterplatte 4 verdrahtet. Die Kurzschlußunterbrecher 11 dienen dazu, im Gegenstecker vorhandene, federnde Kurzschlußbrücken zu trennen, indem sie zwischen die beiden jeweiligen, sich normalerweise gegenseitig berührenden und damit einen Kurzschluß herstellenden Federkontakten des Gegensteckers eingeführt werden und hierdurch den Kurzschluß der jeweiligen Kurzschlußbrücken aufheben. Diese Kurzschlußbrücken sind dazu vorgesehen, Fehlfunktionen des an das Steuergerät 1 anzuschließenden Geräts während dessen Handhabung, das heißt im noch nicht mit dem Steuergerät 1 verbundenen Zustand, zu vermeiden. Das Gerät kann beispielsweise eine oder mehrere Zündpillen eines Insassenschutzsystems, insbesondere eines Airbagsystems, enthalten. Die Kurzschlußbrücken stellen sicher, daß parallel zu den Zündpillen oder sonstigen, zu schützenden Schaltungskomponenten, ein Kurzschluß vorliegt, so daß Spannungen oder Ströme, die durch unabsichtliche Berührung potentialführender Komponenten oder durch Störeinstreuungen verursacht werden, nicht auf die Zündpillen einwirken können. Dieser Schutzzustand wird erst bei Einführung des Gegensteckers in das Steckerverbinderelement 7 durch die Kurzschlußunterbrecher 11 aufgehoben, so daß die Zündpillen (oder sonstigen zu steuernden Schaltungskomponenten) nachfolgend durch das Steuergerät 1 in situationsangepaßter Weise gesteuert werden können.

Zur Befestigung des Steuergeräts 1 an der vorgesehenen Einbauposition sind am Gehäuse 2 an dessen Unterseite Anlageflansche 13 ausgebildet, die über Schrauben mit der Steuergerät-Auflagefläche verschraubbar sind.

Wie aus Fig. 3 ersichtlich ist, liegen die Ebenen der Kontaktstifte 10 und der Unterbrecherstifte 11 oberhalb der Leiterplattenoberseite, so daß die Kontaktstifte 10 in einfacher Weise durch die gebogenen, nach unten geführten Verbindungsdrähte 12 mit den Leiterplattenanschlüssen verbunden werden können. Insgesamt liegt der gesamte Einsteckraum 9 sowie die Wandung 8 oberhalb des Leiterplattenniveaus.

In Fig. 4 ist eine Seitenansicht des in Fig. 3 dargestellten Steuergeräts 1 dargestellt, die gemäß Fig. 3 von rechts gesehen ist und damit einen Einblick in den Einsteckraum 9 ermöglicht. Wie in Fig. 4 gezeigt ist, sind alle Kontaktstifte 10 in zwei parallelen Reihen angeordnet, wobei die Kurzschlußunterbrecher 11 in der gleichen (unteren) Reihe wie die Stekkerstifte 10 angeordnet sind und sich mit diesen abwechseln. Die Kurzschlußunterbrecher 11 belegen zwei oder drei Kontaktstift-Rasterplätze, so daß die Anzahl von zur Verfügung stehenden Kontaktstiften durch die Kurzschlußunterbrecher verringert ist. Bei dem dargestellten Steckverbinderelement 7 handelt es sich um einen 50-poligen, zweireihigen Stecker, bei dem aber bei Einsatz von zum Beispiel acht, jeweils zwei Kontaktstift-Rasterplätze belegenden Kurzschlußunterbrechern 11 lediglich maximal 34 Kontaktstifte belegbar sind.

Wenn versucht wird, die Anzahl von Kontaktstiften zu erhöhen, muß die Baugröße des Steuergeräts 1 vergrößert werden, was nachteiligerweise zusätzlichen Montageraum erfordert.

Aus der DE 44 36 547 A1 ist eine dem Oberbegriff des Patentanspruchs 1 entsprechende Schaltung mit Gehäuse bekannt, bei der an einer Gehäuseseitenwand ein Steckverbinderelement mit einem Einsteckraum angeordnet ist, in dem eine Mehrzahl von in unterschiedlichen Höhenlagen angeordneten Kontaktstiften vorhanden ist. Diese Kontaktstifte sind rückseitig mit entsprechenden Anschlüssen der internen Leiterplatte verbunden.

In der DE 91 09 488 U1 ist eine elektrische Steckverbindung beschrieben, in deren Gehäuse zwei parallele Reihen von nebeneinanderliegenden Kontaktkammern vorhanden sind. In der einen Kontaktkammer-Reihe sind Kontaktemente angeordnet, während in der anderen Kontaktkammer-Reihe Kurzschlußunterbrecherelemente vorgesehen sind.

Der Erfindung liegt die Aufgabe zugrunde, eine mit Gehäuse versehene elektrische Schaltung zu schaffen, die bei geringer Bauhöhe und guter Montierbarkeit mit einer Vielzahl von Kontaktelementen und Kurzschlußunterbrechern versehbar ist.

Diese Aufgabe wird mit den im Patentanspruch 1 genannten Merkmalen gelöst.

Eine vorteilhafte Ausgestaltung der Erfindung ist im Patentanspruch 2 angegeben.

Bei der erfindungsgemäßen Schaltung ist das Steckverbinderelement vergrößert ausgebildet, und nützt auch denjenigen Bauraum aus, der seitlich unterhalb des Leiterplattenniveaus zur Verfügung steht. Damit wird ein vergrößerter Einsteckraum geschaffen, der eine erhöhte Anzahl von Kontaktelementen und/oder Kurzschlußunterbrechern aufnehmen kann, ohne daß sich die Gesamtbauhöhe des Gehäuses, und damit der Schaltung (zum Beispiel Steuergerät) vergrößert. Somit können die Außenabmessungen der Schaltung trotz Erhöhung der Kontaktmöglichkeiten beibehalten werden, so daß kein vergrößerter Montageraum bereitgestellt werden muß.

In dem Steckverbinderelement ist diejenige Reihe, die am nächsten bei der Leiterplatte (auf, oberhalb oder unterhalb der Leiterplattenebene) liegt, durchgehend mit Kurzschlußunterbrechern belegt, so daß in dieser Reihe keine Kontaktelemente angeordnet sind. Hierdurch ist die Verdrahtung mit der Leiterplatte vereinfacht, da die zu verdrahtenden Kontaktelemente deutlich oberhalb der Leiterplattenebene liegen und durch gekrümmte Verbindungsdrähte mit der Leiterplatte verbunden werden können. Dem gegenüber fordern die Kurzschlußunterbrecher keinerlei Verdrahtung, so daß deren enge räumliche Nähe zur Leiterplattenebene keine Verdrahtungsprobleme begründet. Trotz Bereitstellung einer zusätzlichen Stiftreihe (Kurzschlußunterbrecher) in dem Stecker erhöhen sich folglich die Verdrahtungsprobleme, insbesondere im Hinblick auf die Führung der Verbindungsdrähte in unterschiedlichen Höhenlagen, nicht.

Vorzugsweise sind im Stecker drei parallele Reihen vorhanden, wobei alle Kurzschlußunterbrecher in der untersten, am nächsten bei der Leiterplatte liegenden Reihe angeordnet sind und die beiden anderen parallelen Reihen durchgehend mit Kontaktelementen (Kontaktstiften oder Kontaktbuchsen) belegt sind, so daß sich eine Verdrahtung mit hoher Dichte und einer Vielzahl von Kontakten auf engem Raum ergibt.

Die Kontaktelemente können mit den Leiterplattenanschlüsse durch flexible Leiter verbunden sein, sind jedoch vorzugsweise über insbesondere gebogene, steife Verbindungsdrähte mit der Leiterplatte verbunden. Durch Verlöten der Verbindungsdrähte mit der Leiterplatte wird das Steckverbinderelement nicht nur elektrisch angeschlossen, sondern zugleich auch mechanisch abgestützt.

Die Kurzschlußunterbrecher sind durch elektrisch nicht leitende, aus Steckverbindungswandungsmaterial bestehende Stifte oder Stege gebildet. Wenn mehrere oder alle Kurzschlußunterbrecher durch einen Steg gebildet sind, der in eine entsprechende Aufnahmeöffnung des Gegensteckers einführbar ist, kann dort eine Mehrzahl von Kurzschlußbrucken gleichzeitig geöffnet werden. Bei dieser Ausgestaltung zeichnen sich die Kurzschlußunterbrecher durch hohe mechanische Festigkeit aus und sind somit gegenüber Beschädigungen, unerwünschten Verformungen oder dergleichen gut geschützt.

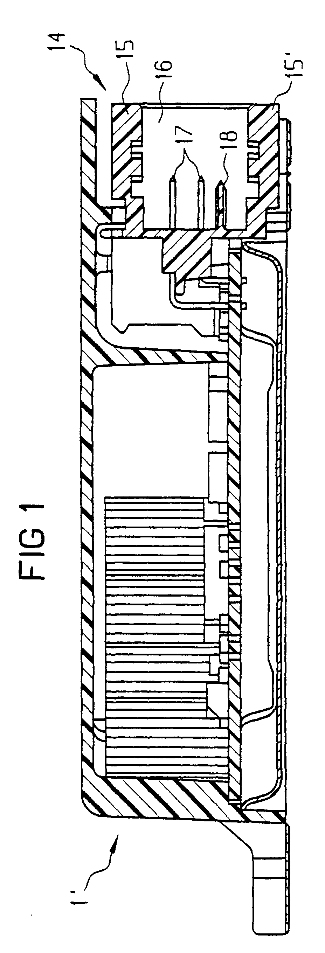

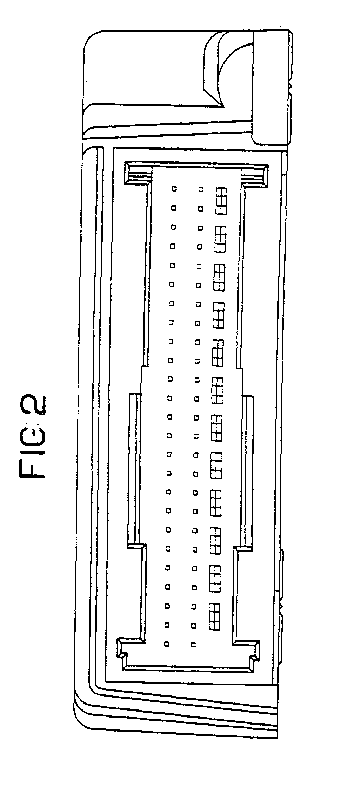

Die Erfindung wird nachstehend anhand eines Ausführungsbeispiels unter Bezugnahme auf die Fig. 1 und 2 näher beschrieben.

Fig. 1 zeigt einen Querschnitt eines Ausführungsbeispiels der erfindungsgemäßen elektrischen Schaltung in Form eines Steuergeräts 1' eines Kraftfahrzeug-Insassenschutzsystems, insbesondere Airbagsystems, während in Fig. 2 eine von rechts (gemäß Fig. 1) gesehene Seitenansicht dargestellt ist. Das Steuergerät 1' besitzt mit Ausnahme des seitlichen Steckverbinderelements im wesentlichen denselben Aufbau wie das in Fig. 3 dargestellte Steuergerät 1. Die übereinstimmenden Komponenten sind mit den gleichen Bezugszeichen versehen und werden nicht nochmals erläutert.

Wie aus den Fig. 1 und 2 ersichtlich ist, ist der von einer Wandung 15 umgrenzte Einsteckraum 16 des Steckverbinderelements (Steckers) 14 größer als in den Fig. 3 und 4 ausgebildet, wobei der untere, dem Deckel 3 benachbarte Wandabschnitt 15' der Wandung 15 unterhalb der Leiterplattenebene liegt. In diesem vergrößerten Einsteckraum 16 sind zwei parallele Reihen von Kontaktelementen 17 angeordnet, die hier die Form von Kontaktstiften aufweisen, jedoch auch als Kontaktbuchsen ausgestaltet sein können. Die Kontaktstifte stehen von der rückseitigen Wand des Einsteckraums 16 rechtwinklig vor. Bei dem dargestellten Ausführungsbeispiel sind 50 Kontaktstifte (zwei Reihen ä 25 Kontaktelemente) vorgesehen, so daß sich eine große Vielzahl von Signalen übertragen läßt. Die Anzahl der Kontaktstifte kann je nach Einsatzzweck erhöht oder verringert sein, wobei dann auch die Anzahl von Kontaktelement-Reihen entsprechend modifiziert werden kann.

Parallel zu den Kontaktelement-Reihen ist eine Reihe von Kurzschlußunterbrechern im Einsteckraum 16 vorgesehen, die von der Rückseitenwand rechtwinklig abstehen und einstückig mit dieser ausgebildet sind, das heißt durch das isolierende Wandmaterial gebildet sind. Die Kurzschlußunterbrecher 18 können auch auf diese vorstehenden Abschnitte aufgeschobene Kunststoffkappen enthalten und bewirken eine Auftrennung der im nicht dargestellten Gegenstecker an entsprechenden Positionen vorgesehenen Kurzschlußbrücken. Die Kurzschlußunterbrecher 18 sind in der untersten, das heißt der am nächsten bei der Leiterplattenebene liegenden Reihe positioniert. Da die Kurzschlußunterbrecher 18 keinerlei elektrische Verdrahtung mit der Leiterplatte 4 erfordern, ergeben sich trotz dieser engen Nähe zur Leiterplatte keine Leiterführungsprobleme. Die Verdrahtung der Kontaktelemente 17 mit der Leiterplatte 4 kann damit trotz Vorhandensein einer dritten Funktionsreihe im Stecker in gleicher Weise wie bei den Fig. 3 und 4 mit Hilfe von in nur zwei Lagen angeordneten Verbindungsdrähten 12 ausgeführt werden, die von beiden Kontaktelementreihen zunächst in deren Höhenlage verlaufen und anschließend rechtwinklig nach unten bis zur Leiterplatte entlang zweier paralleler Ebenen geführt sind.

Bei dem in den Fig. 1 und 2 gezeigten Ausführungsbeispiel sind alle Kurzschlußunterbrecher in der untersten Reihe angeordnet. Sollten jedoch zusätzliche Kurzschlußunterbrecher erforderlich sein, können diese auch in der mittleren oder oberen-Kontaktelementreihe positioniert werden. Umgekehrt sollte jedoch vermieden werden, in der untersten Kurzschlußunterbrecher-Reihe Kontaktelemente anzuordnen, die separat mit der Leiterplatte über einzelne Verbindungsleitungen kontaktiert werden müßten.

Wie aus Fig. 1 ersichtlich ist, ist die Kurzschlußunterbrecher-Reihe in einer Ebene angeordnet, die geringfügig oberhalb der Ebene der Leiterplattenoberseite liegt. Die Kurzschlußunterbrecher können aber auch in der gleichen Höhenlage wie die Leiterplatte oder sogar unterhalb dieses Niveaus angeordnet werden. Ferner können die in Fig. 2 gezeigten einzelnen Kurzschlußunterbrecher 18 auch durch eine einzige, durchgehende Leiste aus elektrisch isolierendem Material, zum Beispiel dem Steckerwandungsmaterial, gebildet sein. Die Leiste kann hierbei auch in mehrere getrennte Teilleisten unterteilt sein, so daß nicht alle, sondern nur jeweils einige Kurzschlußunterbrecher durch Leistenabschnitte gebildet sind.

Durch die Verlagerung der Kurzschlußunterbrecher (Kunststoffzungen) 18 in die unterste Kontaktreihe und die Vergrößerung des Einsteckraums 16 nach unten läßt sich der unterhalb der Leiterplatte befindliche Gehäusebauraum für die Steckverbinderfunktion ausnützen. Die Gesamtbauhöhe läßt sich folglich sehr kompakt halten.

Das in den Fig. 1 und 2 nicht gezeigte, mit dem Steckverbinderelement 14 zu verbindende Gegensteckverbinderelement enthält die Kontaktelemente und Kurzschlußunterbrecher in einer an das Steckerverbinderelement 14 angepaßten Positionierung und Gruppierung.

Wie insbesondere aus Fig. 2 ersichtlich ist, ist der untere, parallel zur Bodenfläche verlaufende Wandabschnitt der Stekkerwandung 15 seitlich neben dem Anlageflansch 13 im wesentlichen auf dessen Höhenlage angeordnet und weist einen nur geringen Abstand zur Montageauflagefläche auf. Insbesondere aus einem direkten Vergleich der Fig. 2 und 4 ist die deutliche Vergrößerung des Einsteckraums 16 bei der erfindungsgemäßen Schaltung klar erkennbar.

Die Leiterplatte 4 kann im Gehäuse 2 auch in umgekehrter Lage angeordnet sein, so daß die Bauelemente 5 nach unten weisen. In diesem Fall sind die am Gehäuse 2 für die Leiterplatte 4 vorgesehenen Auflageflächen in kleinerem Abstand zu der parallel verlaufenden Gehäusewand angeordnet und es ist der Dekkel 3 so vergrößert, daß er die Bauelemente 5 überspannen kann. Das Steckverbinderelement 14 ist in diesem Fall ebenfalls in umgekehrter Positionierung angeordnet, so daß die Kurzschlußunterbrecher 18 dann in der obersten Reihe, das heißt wiederum näher bei der Leiterplattenebene als die Kontaktelementreihen, angeordnet sind.

## Patentansprüche

1. Mit Gehäuse (2, 3) versehene elektrische Schaltung, insbesondere Steuergerät (1') für Kraftfahrzeuge, mit einer in dem Gehäuse (2, 3) angeordneten, Schaltungselemente (5) tragenden Leiterplatte (4) und einem am Gehäuse (2, 3) angeordneten Steckverbinderelement (14), das einen nach außen offenen, durch eine Wandung (15) umgrenzten Einsteckraum (16) mit mehreren in Reihen angeordneten Kontaktelementen (17) aufweist und dessen Wandung (15) sich bis unter das Niveau der Leiterplatte (4) erstreckt, **dadurch gekennzeichnet, daß** mehrere Kurzschlußunterbrecher (18) vorhanden sind, die in einer keine Kontaktelemente (17) enthaltenden Reihe derart angeordnet sind, daß die Kurzschlußunterbrecher-Reihe unterhalb der Kontaktelement-Reihen und näher bei der Leiterplattenebene liegt als die Kontaktelement-Reihen, und daß die Kurzschlußunterbrecher (18) durch einstückig mit der rückseitigen Steckverbinderwandung ausgebildete, elektrisch nicht leitende Stifte oder durch einen oder mehrere durchgehende, mindestens zwei Unterbrecherpositionen überspannende Stege aus Steckverbindungswandungsmaterial gebildet sind.

2. Schaltung nach Anspruch 1, **dadurch gekennzeichnet, daß** die Kontaktelemente (17) durch vorzugsweise gebogene Verbindungsleitungen, insbesondere formstabile Leiter, mit der Leiterplatte (4) verbunden sind.

## Claims

1. Electric circuit provided with a housing (2, 3), in particular a control device (1') for motor vehicles, having a printed circuit board (4) arranged in the housing (2, 3) and bearing circuit elements (5), and a plug-in connector element (14) which is arranged on the housing (2, 3), has a plug-in chamber (16) that is open to the outside, enclosed by a wall (15) and has a number of contact elements (17) arranged in rows, and whose wall (15) extends downwards below the level of the printed circuit board (4), **characterized in that** there are a number of short-circuit interrupters (18) which are arranged in a row that contains no contact elements (17), in such a way that the row of short-circuit interrupters is located beneath the rows of contact elements and closer to the printed circuit board plane than the rows of contact elements, and **in that** the short-circuit interrupters (18) are formed by electrically non-conductive pins that are formed in one piece with the rear plug-in connector wall or by one or more continuous webs of plug-in connection wall material that cover at least two interrupter positions.

2. Circuit according to Claim 1, **characterized in that** the contact elements (17) are connected to the printed circuit board (4) by means of preferably bent connecting, lines, in particular dimensionally stable conductors.

## Revendications

1. Circuit électrique pourvu d'un boîtier (2, 3), notamment dispositif de commande (1') pour véhicule automobile, comprenant une plaquette de circuit imprimé (4), qui porte des éléments de circuit (5) disposés dans le boîtier (2, 3), et un élément connecteur à enfichage (14) qui est disposé sur le boîtier (2, 3), qui comprend un espace d'emboîtement (16), ouvert vers l'extérieur, délimité d'une manière enveloppante par une paroi (15) et comportant plusieurs éléments de contact (17) disposés en rangées, et dont la paroi (15) s'étend jusqu'au-dessous du niveau de la plaquette de circuit imprimé (4), **caractérisé en ce qu'**il existe plusieurs éléments de rupture de court-circuit (18) qui sont disposés en une rangée ne contenant pas d'éléments de contact (17), d'une manière telle que la rangée d'éléments de rupture de court-circuit est située au-dessous des rangées d'éléments de contact et plus près du plan de la plaquette de circuit imprimé que les rangées d'éléments de contact, et **en ce que** les éléments de rupture de court-circuit (18) sont formés de broches électriquement non conductrices, réalisées d'une seule pièce avec la paroi de connecteur à enfichage située du côté arrière, ou d'une ou plusieurs barrettes continues, constituées de la matière de la paroi de connecteur à enfichage, qui recouvrent au moins deux positions d'élément de rupture.

2. Circuit suivant la revendication 1, **caractérisé en ce que** les éléments de contact (17) sont reliés à la plaquette de circuit imprimé (4) au moyen de lignes de liaison, de préférence pliées, notamment de conducteurs indéformables.
